# EUROPEAN PATENT APPLICATION

(11) **EP 1 093 232 A1**
(43) Date of publication of application: **18.04.2001**
(21) Application number: 00912897.6
(22) Date of filing: 29.03.2000
(51) Int. Cl.: H03M 13/27

(54) **PROCESSOR AND PROCESSING METHOD**

(30) Priority: 02.04.1999 JP 9700299
(71) Applicant: MATSUSHITA ELECTRIC INDUSTRIAL CO., LTD., Kadoma-shi, Osaka 571-8501 (JP)
(72) Inventor: YAMANAKA, Ryutaro, Konan-ku, Yokohama-shi, Kanagawa 233-000 (JP)
(74) Representative: Grünecker, Kinkeldey, Stockmair & Schwanhäusser Anwaltssozietät
(86) International application number: JP0001931
(87) International publication number: WO0060749

(57) **Abstract**

The interleaving/deinterleaving processing is executed in one machine cycle in which input data is arranged and stored at storage areas with contiguous addresses in RAM 103, the stored data is read with two times the accuracy in the order of address in RAM 103 corresponding to an address from first pointer 101 and an address front address generator 102, and one item of the read data is stored at a storage area with an even address in RAM 110 using an address from second pointer 106 and an address from address generator 107, while the other item of the read data is stored at a storage area with an odd address a predetermined value away from the even address in RAM 110 using an address from third pointer 108 and an address from address generator 109. It is thereby possible to achieve miniaturization, one-chip structure and cost reduction in a DSP and further achieve low power consumption battery, light-weighting, and cost reduction in a portable terminal device.

## Description

### Technical Field

The present invention relates to a calculation processing device and method which are incorporated in a communication terminal apparatus, base station apparatus and the like in a mobile communication system, and in particular which efficiently perform block interleaving processing in which data with a matrix arrangement written in row direction is read in column direction.

### Background Art

A digital signal processor (hereinafter referred to as DSP) has been widely employed while being adapted to a digital mobile communication field, for example, as a processor to be assembled in a portable telephone.

In a data communication using a mobile radio communication channel, a burst error frequently occurs due to an effect of, for example, multipath fading. Such a communication with the burst error generally employs an interleaving technique along with an error correcting code such as a convolutional code.

The interleaving technique is composed of interleaving processing in which a transmission side (channel coder) separates an input sequence greatly prior to outputting to diffuse a burst error and deinterleaving processing in which a reception side (channel decoder) reads received data in a predetermined order, and each processing is mainly executed with the DSP.

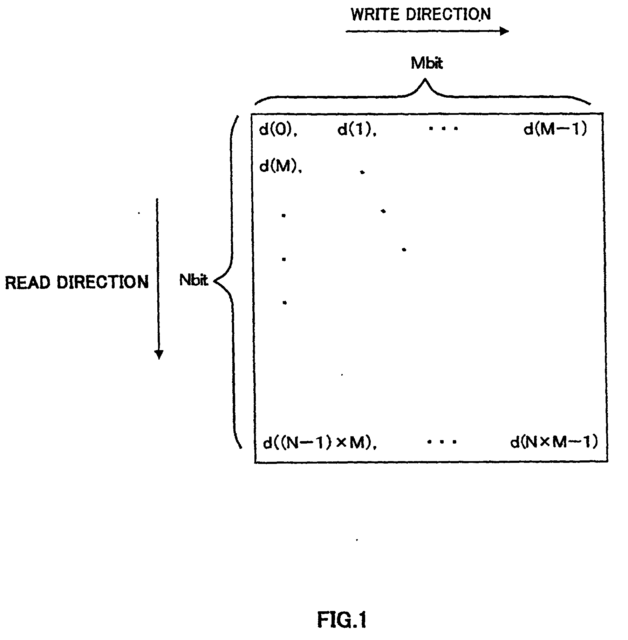

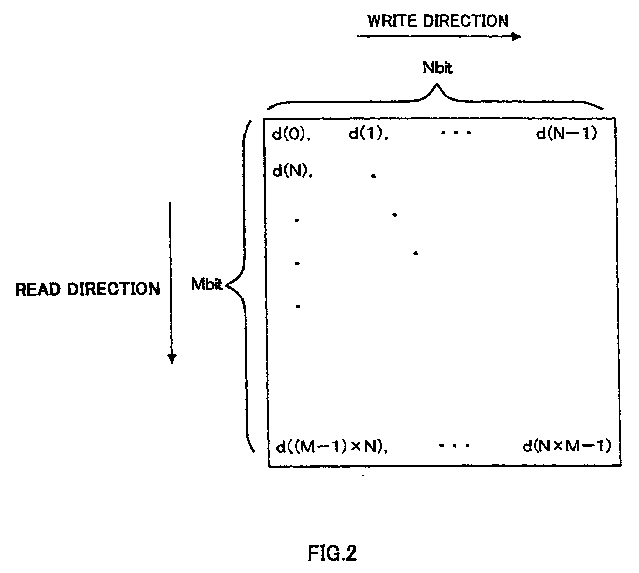

An explanation is next given of a block interleaving method, one of the interleaving techniques, often used generally with reference to FIGs.1 and 2.

In the interleaving processing, as illustrated in FIG.1, assuming a memory space divided into N bits and M bits respectively in a vertical direction and in a horizontal direction with respect to input data of L=N × M bits, input data is written in the horizontal direction and output data is read in the vertical direction, in FIG.1 {hereinafter represented as L(N,M)}.

Meanwhile, in the deinterleaving processing, as illustrated in FIG.2, assuming a memory space divided into M bits and N bits respectively in a vertical direction and in a horizontal direction, input data is written in the horizontal direction and output data is read in the vertical direction, in FIG.2. That is, the deinterleaving processing is represented as L(M,N).

According to the foregoing, the interleaving processing and deinterleaving processing has the same operation except that the number of bits is exchanged between the vertical direction and the horizontal direction.

When the above interleaving processing is executed with a DSP, L machine cycles corresponding to at least one clock are required to transfer data of L bits, N machine cycles or M machine cycles are further required to re-set addresses on a read side or write side every M bits or every N bits, respectively, and therefore, at least total L+N or L+M machine cycles are required.

It is expected that a demand on a non-speech commination such as data transmission in a radio mobile communication will be further increased in the future. The non-speech communication generally has a greater information amount than a speech communication. As the information amount is increased, a processing amount required for the interleaving/deinterleaving processing is increased.

Meanwhile, it is important in the mobile radio communication and the like to maintain a life of a battery of a portable terminal device for a long time. The battery lasts longer as the processing amount of the DSP is smaller.

With respect to the portable terminal device, there are further required its miniaturization, light-weighting and cost reduction, as well as the foregoing. Therefore it is attempted in the portable terminal device that processing conventionally executed with a dedicated LSI is executed with one chip according to DSP processing.

In a conventional apparatus, however, there is a tendency that a processing amount required for the interleaving and deinterleaving is increased, and in proportional to the increased amount, a calculation amount of the DSP (calculation processing device) that executes the processing tends to be increased.

Therefore, power consumption in the calculation is increased, resulting in a problem that it is difficult to maintain a battery of a portable terminal device using the DSP for a long time.

Further, the increased calculation amount may exceed a processing capability of a preexisting DSP, resulting in another problem that the DSP may not be achieved with one chip.

Furthermore, a large-scale hardware investment to improve functions of the DSP introduces an increased cost of the DSP, and as a result, there occurs the other problem that it is not possible to achieve the miniaturization, light-weighting and cost reduction of the portable terminal device.

### Disclosure of Invention

It is an object of the present invention to provide a calculation processing device and method which perform interleaving/deinterleaving processing with as small a calculation amount as possible, and thereby enable miniaturization, one-chip structure and cost reduction of a DSP and further enable a low power consumption battery, light-weighting and cost reduction of a portable terminal device.

This object is achieved by arranging in the interleaving/deinterleaving processing an input sequence at contiguous addresses in a memory, loading the sequence sequentially with two times the accuracy as the arrangement, storing data at an even address in an address designated by an address generator dedicated for even addresses, and concurrently storing data at an odd number in an address designated by another address generator dedicated for odd addresses, and thereby processing the interleaving or deinterleaving processing of two items of data in one machine cycle.

### Brief Description of Drawings

FIG.1 is an operation explanation diagram of block interleaving of input data of L(N,M);
FIG.2 is an operation explanation diagram of block interleaving of input data of L(M,N);
FIG.3 is a block diagram illustrating a calculation processing device according to a first embodiment of the present invention;
FIG.4 is an address/data structure diagram to explain a data transfer operation in block interleaving in the calculation processing device according to the first embodiment of the present invention;
FIG.5 is a timing diagram to explain a pipeline operation in the calculation processing device according to the first embodiment of the present invention;
FIG.6 is a timing diagram to explain the data transfer operation in the block interleaving in the calculation processing device according to the first embodiment of the present invention;
FIG.7 is a block diagram illustrating a configuration of a communication terminal apparatus according to a second embodiment of the present invention;
FIG.8 is a block diagram illustrating a configuration of a communication terminal apparatus according to a third embodiment of the present invention;
FIG.9 is a block diagram illustrating a configuration of a base station apparatus according to a fourth embodiment of the present invention; and
FIG.10 is a block diagram illustrating a configuration of a base station apparatus according to a fifth embodiment of the present invention.

### Best Mode for Carrying Out the Invention

Embodiments of the present invention are explained below with reference to accompanying drawings.

### (First embodiment)

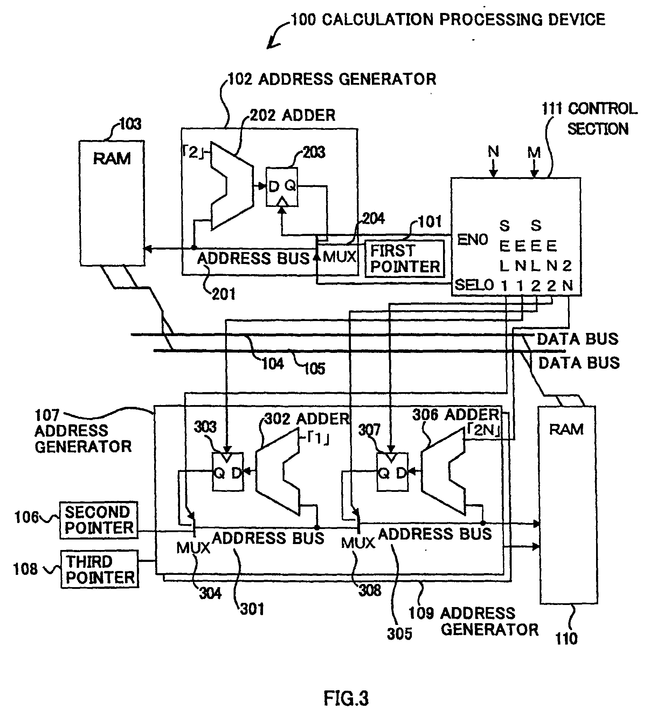

FIG.3 is a block diagram illustrating a calculation processing device according to the first embodiment of the present invention.

Calculation processing device 100 illustrated in FIG.3 is comprised of first pointer 101, address generator 102, RAM 103, two data buses 104 and 105 which perform data transfer, second pointer 106, address generator 107, third pointer 108, address generator 109, RAM 110 and controller 111.

Address generator 102 is comprised of address bus 201, adder 202, flip-flop 203, and multiplexer (MUX) 204. Address generator 102 generates an address in RAM 103 corresponding to an address designated by first pointer 101. RAM 103 outputs to data buses 104 and 105 data stored in a storage area with the address designated by address generator 102.

Each of address generators 107 and 109 is comprised of address bus 301, adder 302, flip-flop 303, multiplexer 304, address bus 305, adder 306, flip-flop 307, and multiplexer 308. Address generator 107 generates an address in RAM 110 corresponding to an address designated by second pointer 106, while address generator 109 generates an address in RAM 110 corresponding to an address designated by third pointer 108.

Data items on data buses 104 and 105 are respectively stored at respective addresses designated by address generators 107 and 109 in RAM 110.

Control section 111 receives as its inputs N and M of L(M,N) that is input data format in the block interleaving as explained in the conventional example, outputs write enable signals EN0, EN1 and EN2 to flip-flops 203, 303 and 307 of three address generators 102, 107 and 109, further outputs selection signals SEL0, SEL1 and SEL2 to multiplexers 204, 304 and 308, respectively, and controls data 2N to be output to adder 306.

Address bus 201 performs, for example, transfer to an address designated by first pointer 101. Adder 202 adds the address designated by first pointer 101 input through address bus 201 and "2" as a set address.

Flip-flop 203 holds an address obtained from the addition in adder 202 corresponding to the write enable signal EN0 output from control section 111.

Multiplexer 204 selects the address held at flip-flop 203 and the address designated by first pointer 101, corresponding to the selection signal SEL0 output from control section 111, to output to address bus 201.

Address bus 301 performs, for example, transfer to an address designated by second pointer 106. Adder 302 adds the address designated by second pointer 106 input through address bus 301 and "1" as a set address.

Flip-flop 303 holds an address obtained from the addition in adder 302 corresponding to the write enable signal EN1 output from control section 111.

Multiplexer 304 selects alternately the address held at flip-flop 303 or the address designated by second pointer 106, corresponding to the selection signal SEL1 output from control section 111, to output to multiplexer 308 through address bus 301.

Adder 306 adds the address output from multiplexer 308 through address bus 305 and address "2N" output from control section 111.

Flip-flop 307 holds an address obtained from the addition in adder 306 corresponding to the write enable signal output from output terminal EN2 of control section 111.

Multiplexer 308 selects alternately the address held at flip-flop 307 or the address input from multiplexer 304 through address bus 301, corresponding to the selection signal SEL2 output from control section 111, to output to address bus 305.

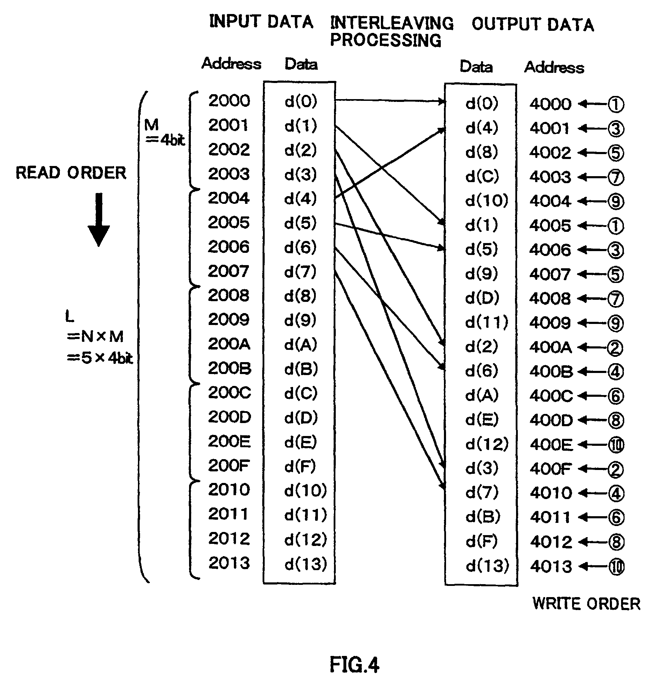

An explanation is next given of the operation for data transfer of block interleaving in calculation processing device 100 with the above configuration with reference to FIG.4.

In addition, an example is shown of processing for subjecting input data of 20 bits stored at contiguous addresses starting from address 2000h in RAM 103 to block interleaving of L(N,M)=20(5,4) to store the data at contiguous addresses starting from address 4000h in RAM 110.

As illustrated in FIG.4, data d(0) at the address 2000h in RAM 103 is stored at address 4000h in RAM 110, and data d(1) at address 2001h is stored at address 4000h+N=4005h.

Next, data d(2) at address 2002h is stored at address 4000h+2N=400Ah, and data d(3) at address 2003h is stored at address 4000h+3N=400Fh.

After the transfer of M(=4) bits is thus completed, data items of M(=4) bits at next addresses 2004h to 2007h are respectively stored in the same way as the foregoing at addresses 4001h, 40006h, 400Bh and 4010h separate by N(=5) addresses.

A series of the transfer of M(=4) bits is repeated total N(=5) times, and thereby the interleaving processing is completed. The order of writing in RAM 110 in this interleaving processing is shown in FIG.4 with ① to 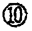 .

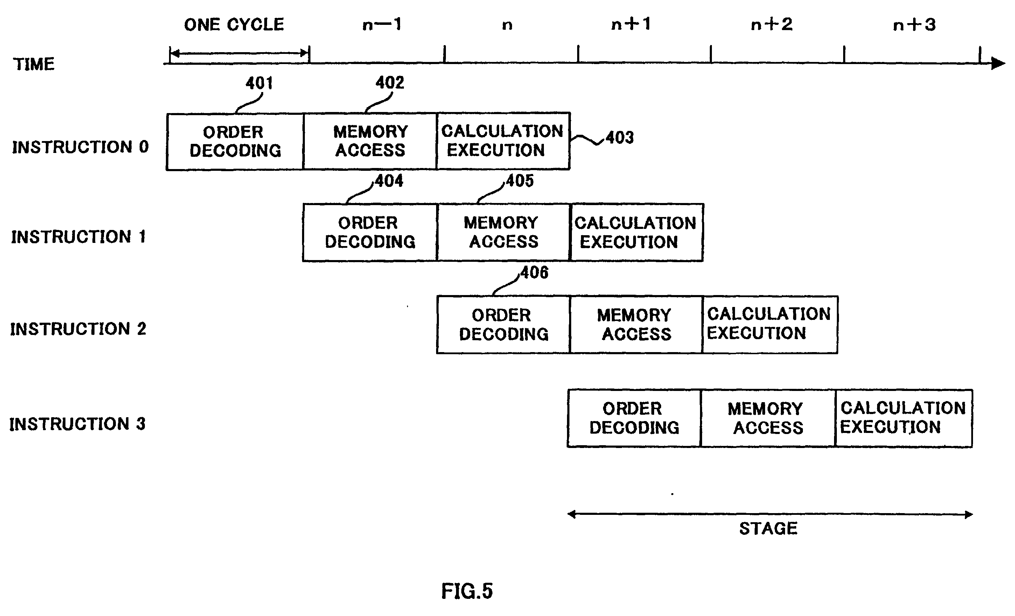

Calculation processing device 100 is suitable for calculation processing of a pipeline structure illustrated in FIG.5. It is herein assumed that each value of N(=5) and M(=4) bits is input to control section 111 at operation decoding stage 401 equivalent to one cycle time (corresponding to a clock) at instruction 0, data is read from RAM 103 corresponding to the input value at memory accessing stage 402, and that the read data is written in RAM 110 at calculation executing stage 403.

Further, during the processing of memory accessing stage 402 at the instruction 0, processing of operation decoding stage 404 at next instruction 1 is executed, and during the processing of calculation executing stage 403 at the instruction 0, processing of memory accessing stage 405 at the instruction 1 is executed, while processing of operation decoding stage 406 at next instruction 2 is executed.

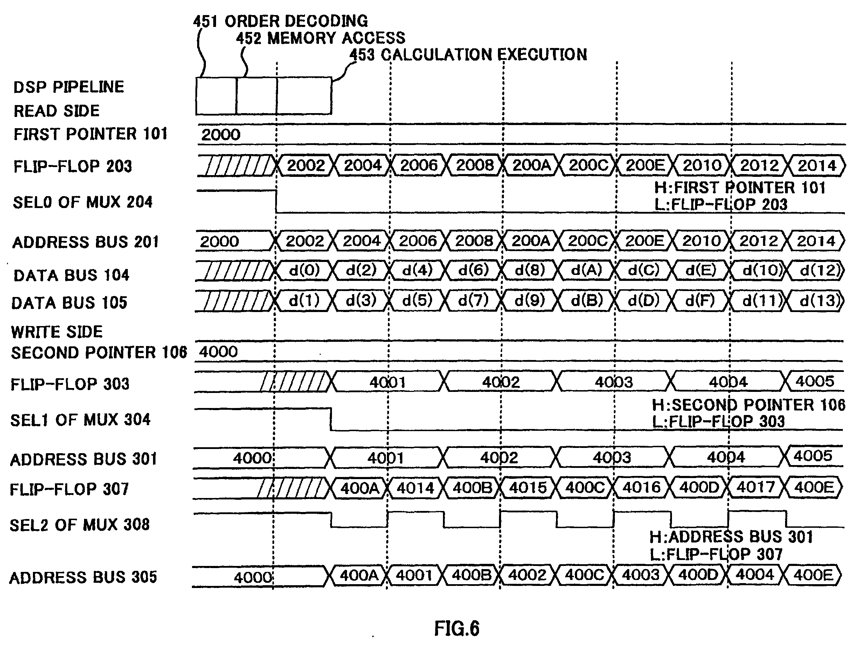

An explanation is next given of the operation of the interleaving processing in the calculation processing with such a pipeline structure with reference to an operation timing diagram in FIG.6.

As an initial setting, a read address is set to 2000h in first pointer 101, a write address is set to 4000h in second pointer 106, and a write address is set in third pointer 108 to 4005h greater than the address in second pointer 106 by N(=5). Further, information of N(=5) and M(=4) is set in control section 111.

In the interleaving processing, as illustrated in FIG.6, when address 2000h is designated by first pointer 101, at memory access stage 542, a data item at address 2000h and another data item at address 2001h are read from RAM 103, thereby performing the read with two times the accuracy as the designation, to be output to data buses 104 and 105 respectively.

Further, address generator 102 stores address 2002h, which is a result obtained in adder 202 by adding data on address bus 201 (2000h at this time) and set address "2", in flip-flop 203 as a next read address corresponding to the selection signal SEL0.

That is, multiplexer 204 selects an output of first pointer 101 corresponding to an "H" level of the selection signal SEL0 to output to address bus 201 for the first time, and selects an output of flip-flop 203 corresponding to an "L" level of the selection signal SEL0 to output to address bus 201 for the second time and thereafter.

Then, at calculation executing stage 453, data on data bus 104 is stored in a storage area with address 4000h in RAM 110 designated by second pointer 106, while data on data bus 105 is, not shown in the figure, stored in a storage area with address 4005h in RAM 110 designated by third pointer 108.

Further, address generator 107 stores address 400Ah, which is a result obtained in adder 306 by adding data on address bus 305 (4000h at this time) and 2N(=10), in flip-flop 307 as a next write address.

Multiplexer 308 selects an output of address bus 301 corresponding to an "H" level of the selection signal SEL2 to output to address bus 305 for the first time, and selects an output of flip-flop 307 corresponding to an "L" level of the selection signal SEL2 to output to address bus 305 until M/2th (second) time.

Adder 302 adds the address designated by second pointer 106 and set address "1", and the added result 4001h is stored in flip-flop 303.

Multiplexer 304 selects an output of first pointer 106 corresponding to an "H" level of the selection signal SEL1 to output to address bus 301 for the first time, and selects an output of flip-flop 303 corresponding to an "L" level of the selection signal SEL1 to output to address bus 301 for the second time and thereafter.

Thus, with the pipeline operation by a DSP (calculation processing device 100), the interleaving processing is executed by reading contiguous data items of 20 bits with two times the accuracy, and it is thereby possible to achieve the processing in 10 machine cycles.

Further, the function of reading two data items from a memory is capable of been also used as another two-time calculation function of the DSP, and address generators 102, 107 and 109 are also capable of been used as a function of the DSP of accessing to another memory with a small amount of modifications added.

Furthermore, while the above explanation shows the example of L=20, N=5 and M=4 to simplify the explanation, it may be possible to carry into practice similarly with other values.

Moreover, while the above explanation shows the case where data of 1 bit is stored at one address in an RAM to simplify the explanation, it may be possible to assign any number of bits to one address to carry into practice similarly in the same principle.

Thus, the interleaving/deinterleaving processing is executed in one machine cycle, in which input data is arranged and stored at storage areas with contiguous addresses in RAM 103, stored data is read with two times the accuracy in the order of address, and one item of read data is stored at a storage area with an even address in RAM 110, while the other item of the read data is stored at a storage area with an odd address a predetermined value away from the even address in RAM 110. It is thereby possible to achieve the interleaving/deinterleaving processing with as small a calculation amount as possible, possible to miniaturize a circuit scale of the calculation processing device, and further possible to achieve one-chip structure, low power consumption and low cost of the device.

Further, a first set address to start reading data front RAM 103 is set in first pointer 101, and address generator 102 generates a read address in RAM 103 by increasing the first set address by 2. A second set address to start writing data in RAM 110 is set in second pointer 106, while a third set address, a predetermined value away from the second address, to start writing data in RAM 110 is set in third pointer 108. Address generator 107 alternately generates a first write address by increasing the second set address by 1 and a second write address by adding the first write address and a predetermined value. At this point, address generator 109 generates addresses in RAM 110 by pairing a third write address obtained by increasing the third set address by 1 and the first write address, and further pairing a fourth write address obtained by adding the third write address and a predetermined value and the second write address. It is thereby possible to arbitrarily set addresses for reading and writing data in the interleaving/deinterleaving processing.

Further, a program to achieve calculation processing device 100 with software may be stored in a storage medium such as a magnetic disk, optomagnetic disk, and ROM cartridge, whereby it may be possible to achieve the function of calculation processing device 100 with ease in an apparatus which performs the interleaving/deinterleaving processing.

### (Second embodiment)

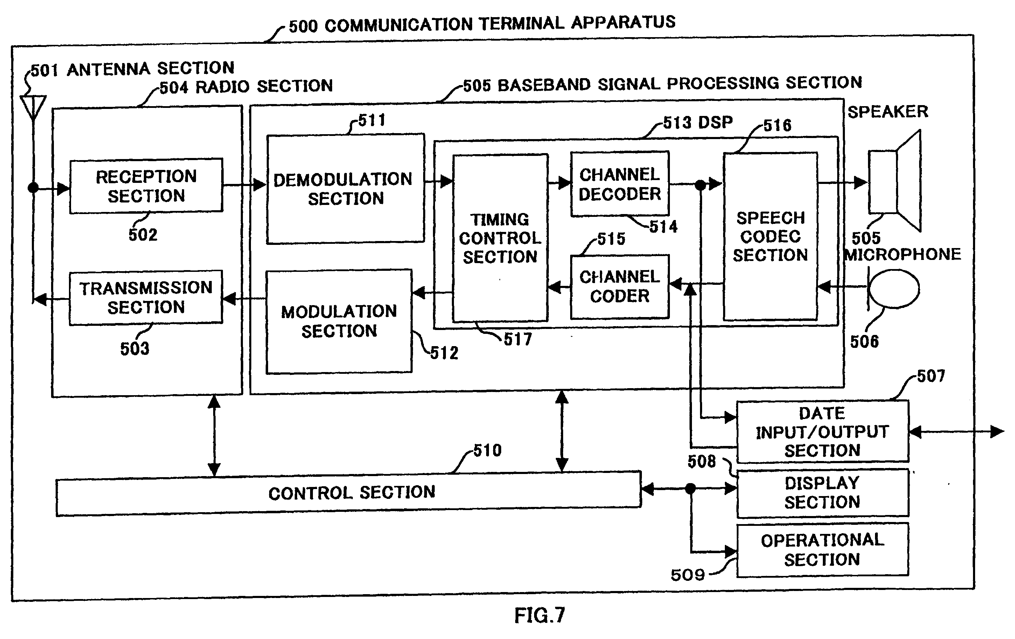

FIG.7 is a block diagram illustrating a configuration of a communication terminal apparatus according to the second embodiment of the present invention.

Communication terminal apparatus 500 illustrated in FIG.7 is configured with calculation processing device 100 in the first embodiment. Communication terminal apparatus 500 is provided with transmission/reception common antenna section 501, radio section 504 comprised of reception section 502 and transmission section 503, and baseband signal processing section 505 that performs modulation/demodulation and coding/decoding of a signal. Communication terminal apparatus 500 is further provided with speaker 520 that outputs a speech, microphone 506 to which a speech is input, data input/output section 507 that receives and outputs transmission data and received data from/to an external apparatus, display section 508 that displays an operation state, and operational section 509 such as a ten-key. Furthermore, communication terminal apparatus 500 is provided with control section 510 that controls sections such as antenna section 501, radio section 504, baseband signal processing section 505 and display section 508 and operational section 509.

Baseband signal processing section 505 is comprised of demodulation section 511 that demodulates a received signal, modulation section 512 that modulates a transmission signal, and DSP 513 of one chip. DSP 513 is comprised of channel decoder 514, composed of calculation processing device 100 in the first embodiment, which decodes the received signal, channel coder 515 that codes the transmission signal, speech codec section 516 that performs coding/decoding of a speech signal, and timing control section 517 each achieved in software. Timing control section 517 provides the received signal output from demodulation section 511 to channel decoder 514, and further provides the transmission signal output from channel coder 515 to modulation section 512 at respective timings of reception and transmission.

Control section 510 in communication terminal apparatus 500 controls the entire operation of communication terminal apparatus 500. For example, control section 510 displays a signal input from operational section 509 on display section 508, and outputs a control signal to perform the operation of calling or answering to antenna section 501, radio section 504 and baseband signal processing section 505 according to a communication sequence, while receiving a signal input from operational section 509.

In the case where a speech is transmitted from communication terminal apparatus 500, a speech signal input from microphone 506 is subjected to A/D conversion (not shown in the figure), the resultant signal is coded in speech codec 516 in DSP 513, and the coded data is input to channel coder 515.

Further in the case where data is transmitted, data input from an external apparatus is input to channel coder 515 through data input/output section 507. Channel coder 515 codes input data to output to timing control section 517.

Timing control section 517 adjusts a transmission output timing of input data, and outputs the data to modulation section 512. The data input to modulation section 512 is subjected to digital modulation and then to D/A conversion (not shown in the figure), and then output to transmission section 503 in radio section 504. Transmission section 503 converts an input signal into a radio signal to output to antenna section 510, and antenna section 510 transmits the radio signal.

Meanwhile, at the time of reception, a radio signal received at antenna section 501 is received in reception section 502 if radio section 504, then subjected to A/D conversion, and output to demodulation section 511 in baseband signal processing section 505. Data demodulated in demodulation section 511 is subjected to timing adjustment in timing control section 517, and output to channel decoder 514 to be decoded.

At the time of a speech communication, data decoded in channel decoder 514 is speech-decoded in speech codec 516, subjected to D/A conversion and output from speaker 520 as a speech.

Further at the time of a data communication, data decoded in channel decoder 514 is output to an external apparatus not shown in the figure through data input/output section 507.

Thus, in communication terminal apparatus 500 in the second embodiment, calculation processing device 100 according to the first embodiment is provided at least in channel decoder 514 that decodes a received signal in DSP 513. It is thereby possible to achieve the interleaving processing of two items of data in one machine cycle with the pipeline processing, and consequently possible to achieve the interleaving processing fast and with a relatively small processing amount, enabling miniaturization, light-weighting, cost reduction and a long-life battery of a portable terminal device (communication terminal apparatus).

Further, since each section of channel decoder 514, channel coder 515, speech codec section 516 and timing control section 517 is composed of software with DSP 513 of one chip, it is possible to assemble communication terminal apparatus 500 with a small number of components.

In addition, while demodulation section 511 and modulation section 512 are separated from DSP 513 in this embodiment, it may be possible to compose these sections using software with DSP 513.

Further, it may be possible to use a DSP as calculation processing device 100 according to the first embodiment, and compose channel coder 514, speech codec section 516 and timing control section 517 with respective different components.

### (Third embodiment)

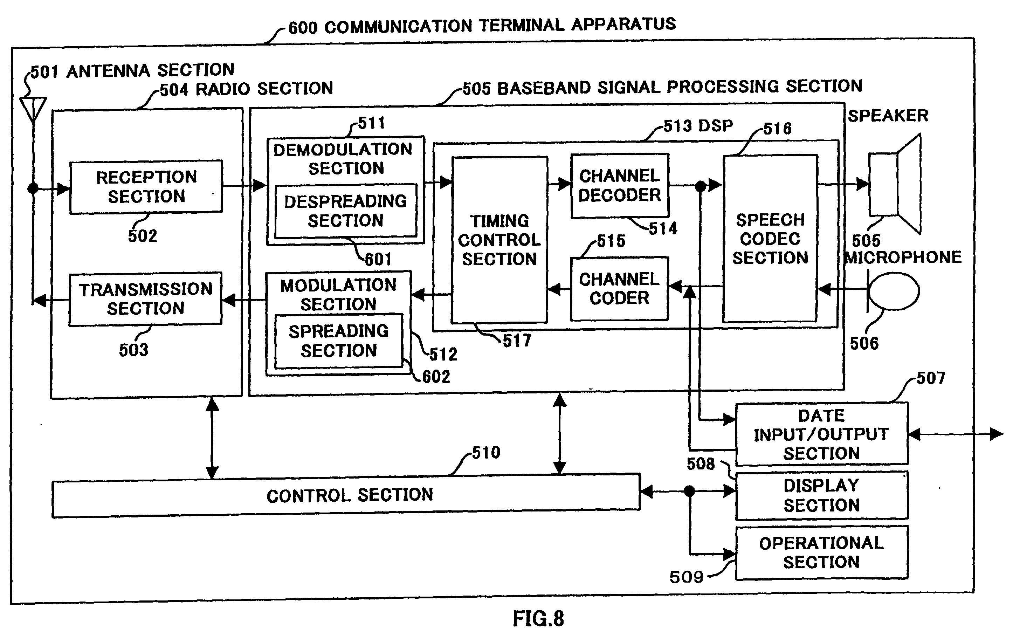

FIG.8 is a block diagram illustrating a configuration of a communication terminal apparatus according to the third embodiment of the present invention. In addition, in communication terminal apparatus 600 illustrated in FIG.8, structural sections common to those in communication terminal apparatus 500 illustrated in FIG.7 are assigned the same reference numerals as those in FIG.7 to omit the explanation thereof.

Communication terminal apparatus 600 illustrated in FIG.8 is different from communication terminal apparatus 500 in the second embodiment in a point that the apparatus 600 is configured as a CDMA (Code Division Multiple Access) communication system communication terminal apparatus in which despreading section 601 is provided in demodulation section 511 and spreading section 602 is provided in modulation section 512.

That is, a received signal input to demodulation section 511 is despread in despreading section 601, and a transmission signal input to modulation section 512 is spread in spreading section 602.

The configuration and operation except the foregoing are almost similar to those of the second embodiment, and further in the CDMA communication, timing control section 517 may include a RAKE reception section that combines a plurality of finger signals selected from, for example, a delay profile (not shown in the figure).

Thus, according to communication terminal apparatus 600 in the third embodiment, since demodulation section 511 is provided with despreading section 601 and modulation section 512 is provided with spreading section 602 to compose the apparatus 600, the apparatus 600 is applicable to the CDMA communication.

### (Fourth embodiment)

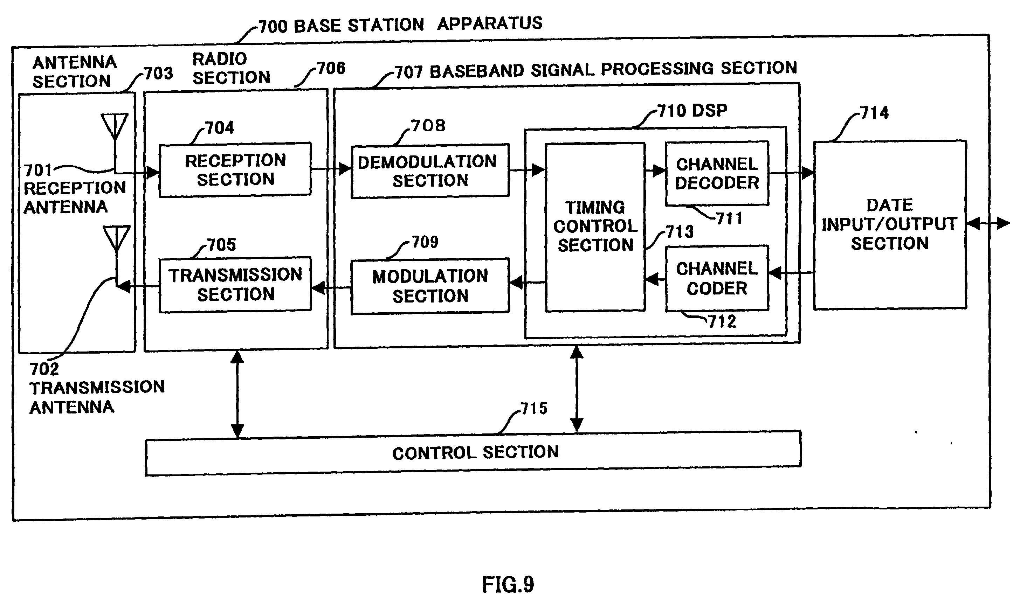

FIG.9 is a block diagram illustrating a configuration of a base station apparatus according to the fourth embodiment of the present invention.

Base station apparatus 700 illustrated in FIG.9 is configured with calculation processing device 100 in the first embodiment. Base station apparatus 700 is provided with antenna section 703 comprised of reception antenna 701 and transmission antenna 702, radio section 704 comprised of reception section 704 and transmission section 705, baseband signal processing section 707 that performs modulation/demodulation and coding/decoding of a signal, and data input/output section 714 that receives and outputs transmission data and received data from/to a cable line. Base station apparatus 700 is further provided with control section 715 that controls sections such as antenna section 703, radio section 706, and baseband signal processing section 707.

Baseband signal processing section 707 is comprised of demodulation section 708 that demodulates a received signal, modulation section 709 that modulates a transmission signal, and DSP 710 of one chip. DSP 710 is comprised of channel decoder 711 composed of calculation processing device 100 in the first embodiment, channel coder 712 that codes the transmission signal, and timing control section 713 each achieved in software. Timing control section 713 provides the received signal output from demodulation section 708 to channel decoder 711, and further provides the transmission signal output from channel coder 712 to modulation section 709 at respective timings of reception and transmission.

Base station apparatus 700 performs the transmission and reception operation under the control of control section 715. Data input from a cable channel is input to channel coder 712 through data input/output section 714. Channel coder 712 codes input data to output to timing control section 713.

Timing control section 713 adjusts a transmission output timing of input data, and outputs the data to modulation section 709. The data input to modulation section 709 is subjected to digital modulation and then to D/A conversion (not shown in the figure), and then output to transmission section 705 in radio section 706. Transmission section 705 converts an input signal into a radio signal to output to antenna section 703, and antenna section 703 transmits the radio signal.

Meanwhile, at the time of reception, a radio signal received at antenna section 701 is received in reception section 704 of radio section 706, then subjected to A/D conversion, and output to demodulation section 708 in baseband signal processing section 707. Data demodulated in demodulation section 708 is subjected to input timing adjustment in timing control section 713, and output to channel decoder 711 to be decoded.

Data decoded in channel decoder 711 is output to a cable line through data input/output section 714.

Thus, in communication terminal apparatus 700 in the fourth embodiment, calculation processing device 100 according to the first embodiment is provided at least in channel decoder 711 that decodes a received signal in DSP 710. It is thereby possible to achieve the interleaving processing of two items of data in one machine cycle with the pipeline processing, and consequently possible to achieve the interleaving processing fast and with a relatively small processing amount.

Further, since each section of channel decoder 711, channel coder 712, and timing control section 713 is composed of software with DSP 513 of one chip, it is possible to assemble base station 700 with a small number of components.

In addition, while demodulation section 708 and modulation section 709 are separated from DSP 710 in this embodiment, it may be possible to compose these sections using software with DSP 710.

Further, it may be possible to use a DSP as calculation processing device 100 according to the first embodiment, and compose channel coder 711 and timing control section 713 with respective different components.

### (Fifth embodiment)

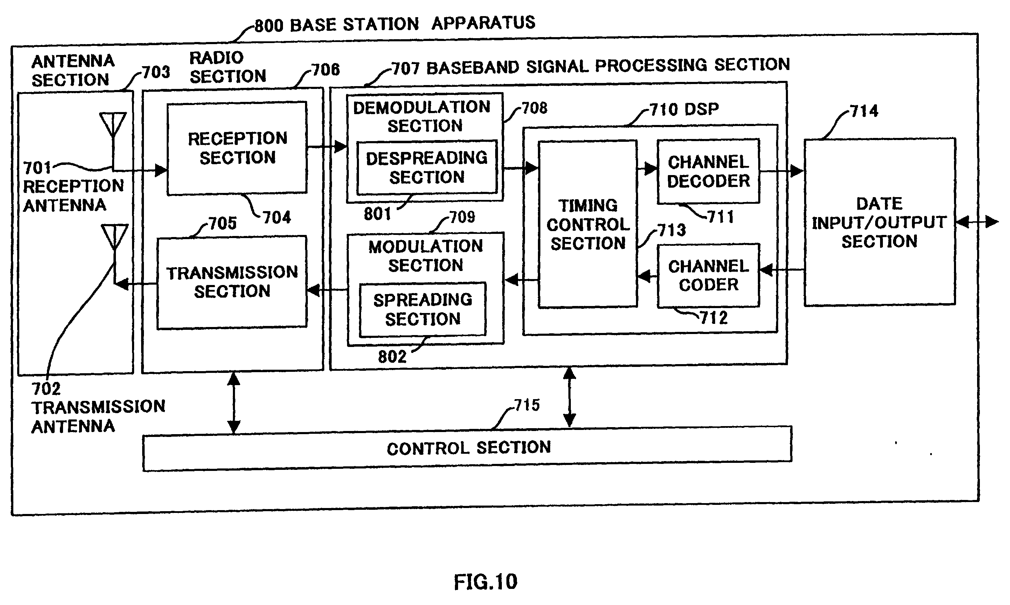

FIG.10 is a block diagram illustrating a configuration of a base station apparatus according to the fifth embodiment of the present invention. In addition, in base station apparatus 800 illustrated in FIG.10, structural sections common to those in base station apparatus 700 illustrated in FIG.9 are assigned the same reference numerals as those in FIG.9 to omit the explanation thereof.

Base station apparatus 800 illustrated in FIG.10 is different from base station apparatus 700 in a point that the apparatus 800 is configured as a CDMA communication system base station apparatus in which despreading section 801 is provided in demodulation section 708 and spreading section 802 is provided in modulation section 709.

That is, a received signal input to demodulation section 708 is despread in despreading section 801, and a transmission signal input to modulation section 709 is spread in spreading section 802.

The configuration and operation except the foregoing are almost similar to those of the fourth embodiment, and further in the CDMA communication, timing control section 713 may include a RAKE reception section that combines a plurality of finger signals selected from, for example, a delay profile (not shown in the figure).

Thus, according to base station apparatus 800 in the fifth embodiment, since demodulation section 708 is provided with despreading section 801 and modulation section 708 is provided with spreading section 802 to compose the apparatus 800, the apparatus 800 is applicable to the CDMA communication.

As described above, according to the preset invention, the interleaving/deinterleaving processing is achieved with as small a calculation amount as possible, whereby it is possible to miniaturize the circuit scale, and thereby possible to achieve one-chip structure, low power consumption and cost reduction.

This application is based on the Japanese Patent Application No.HEI11-097002 filed on April 2, 1999, entire content of which is expressly incorporated by reference herein.

## Claims

1. A calculation processing device comprising a function of performing interleaving/deinterleaving processing in one machine cycle in which input data is arranged and stored at storage areas with contiguous addresses in first storage means, stored data is read with two times accuracy in an order of address, and one item of read data is stored at a storage area with an even address in second storage means, while the other item of the read data is stored at a storage area with an odd address a predetermined value away from the even address in the second storage means.

2. The calculation processing device according to claim 1, further comprising:
first set means in which an address to start reading data from the first storage means is set;
first generating means for generating a read address by increasing the address set in said first set means by 2;
second set means in which an address to start writing data in said second storage means is set;
third set means in which an address, a predetermined value away from the address set in said second set means, to start writing data in said second storage means is set;
second generating means for alternately generating a first write address by increasing the address set in said second set means by 1 and a second write address by adding the first write address and a predetermined value; and
third generating means for alternately generating a third write address by increasing the address set in said third set means by 1 and a fourth write address by adding the third write address and a predetermined value, wherein said first write address and said third write address are made into a pair and said second write address and said fourth write address are made into another pair, each pair being output to second storage means.

3. A digital signal processor comprising the calculation processing device according to claim 1.

4. A communication terminal apparatus comprising the digital signal processor according to claim 3 at least as a function section that decodes a received signal in a baseband signal processing section that demodulates the received signal to decode, while coding a transmission signal to modulate.

5. The communication terminal apparatus according to claim 4, wherein the baseband signal processing section performs CDMA communication system modulation and demodulation.

6. A base station apparatus comprising the digital signal processor according to claim 3 at least as a function section that decodes a received signal in a baseband signal processing section that demodulates the received signal to decode, while coding a transmission signal to modulate.

7. The base station apparatus according to claim 6, wherein the baseband signal processing section performs CDMA communication system modulation and demodulation.

8. A computer readable recording medium having a program recorded therein to execute a function of the calculation processing device according to claim 1.

9. A calculation processing method of performing interleaving/deinterleaving processing in one machine cycle in which input data is arranged and stored at storage areas with contiguous addresses in a first memory, stored data is read with two times accuracy in an order of address, and from read data items at an even address and at an odd address, a data item at the even address is stored at a storage area with an even address in a second memory, while a data item at the odd address is stored at a storage area with an odd address a predetermined value away from the even address in the second memory.

10. The calculation processing method according to claim 9, comprising:
setting a first set address to start reading data from said first memory;
generating a read address by increasing said first set address by 2;
setting a second set address to start writing data in said second memory;
setting a third set address, a predetermined value away from said second set address, to start-writing data in said second memory;
generating alternately a first write address by increasing said second set address by 1 and a second write address by adding said first write address and a predetermined value; and
generating a pair of a third write address generated by increasing said third set address by 1 and said first write address and another pair of a fourth write address generated by adding said third write address and a predetermined value and said second write address.
